# FASCICULE DE BREVET EUROPEEN

(11) **EP 2 359 415 B1**
(45) Date de publication et mention de la délivrance du brevet: **07.02.2018**
(21) Numéro de dépôt: 09803802.9
(22) Date de dépôt: 02.12.2009
(51) Int. Cl.: H01L 31/115, G21H 1/06

(54) **GÉNÉRATEUR ÉLECTRIQUE EXCITÉ PAR RAYONNEMENTS IONISANTS**
DURCH IONISIERENDE STRAHLUNGEN ERREGTER STROMGENERATOR
ELECTRIC GENERATOR EXCITED BY IONISING RADIATIONS

(30) Priorité: 17.12.2008 FR 0858715
(43) Date de publication de la demande: 24.08.2011
(73) Titulaire: Airbus Group SAS, 31700 Blagnac (FR)
(72) Inventeur: MILLER, Florent, 92300 Levallois (FR); BUARD, Nadine, 92190 Meudon (FR); BOUGEROL, Antonin, 92150 Suresnes (FR); WEULERSSE, Cécile, 78000 Versailles (FR)
(74) Mandataire: Ipside
(86) Numéro de dépôt international: PCT/FR2009/052379
(87) Numéro de publication internationale: WO 2010/076449

(56) Documents cités:
- US-A- 3 529 161
- US-A- 5 376 798
- US-B2- 6 949 962
- S. CECCHINI ET AL.: "Solar panels as air Cherenkov detectors for extremely high energy cosmic rays", SIXTH TOPICAL SEMINAR ON NEUTRINO AND ASTROPARTICLE PHYSIC, NUCL.PHYS.PROC.SUPPL., no. 85, 17 mai 1999 (1999-05-17), - 21 mai 1999 (1999-05-21), pages 332-337, XP002548810, San Miniato, Italy

## Description

La présente invention a pour objet un générateur électrique excité par rayonnements ionisants extérieurs au générateur, qu'ils soient d'origine naturelle comme les rayonnements cosmiques ou présents dans certains environnements spécifiques tels les domaines nucléaire ou médical. Le générateur de l'invention comporte une diode qui produit de l'énergie électrique à partir des radiations ionisantes. Constitué d'un matériau semi-conducteur récupérant l'énergie dégagée par les électrons générés par l'effet coulombien, ce générateur est capable de délivrer de l'électricité et a une durée de vie de plusieurs décennies.

On connait le concept de batterie nucléaire depuis les travaux de Philip Edwin Ohmart en 1951. Les cellules de ce type, nucléaires ou beta voltaïques les plus courantes, sont composées d'une diode dopée au tritium, isotope radioactif de l'hydrogène, et utilisent un procédé de conversion non thermique. Ce dopant émet ainsi des rayonnements ionisants dans la diode elle-même. La diode produit alors un courant électrique correspondant. L'inconvénient d'une telle technologie est qu'elle implique de manipuler des matériaux radioactifs.

Par ailleurs, par opposition aux cellules photovoltaïques à base de diode, le générateur de l'invention présente la différence qu'il ne nécessite pas d'être exposé au rayonnement photonique du soleil, à la lumière directe. Au contraire, il peut être placé à l'intérieur d'un véhicule, typiquement un véhicule spatial ou aéronautique, et continuer ainsi à être protégé des projections mécaniques tout en produisant de l'électricité.

Dans l'invention, la solution proposée est d'utiliser comme source d'énergie l'environnement radiatif naturel ou tout autre environnement radiatif ionisant, et non un isotope radioactif présent au sein du générateur.

L'environnement radiatif naturel d'origine cosmique provient du soleil (vent et éruptions solaires) et de l'espace interstellaire et intergalactique qui émettent en permanence des particules de natures et d'énergies très variées, les rayons cosmiques. Il s'agit pour sa partie chargée principalement de protons (entre 85 et 90 %) et de noyaux d'hélium (de 9 à 14 %), le reste étant constitué d'électrons, de différents nucléons (noyaux d'atomes) ainsi que de quantités infimes d'antimatière légère (antiprotons et positrons). La partie neutre est quant à elle constituée de rayons gammas ainsi que de neutrinos.

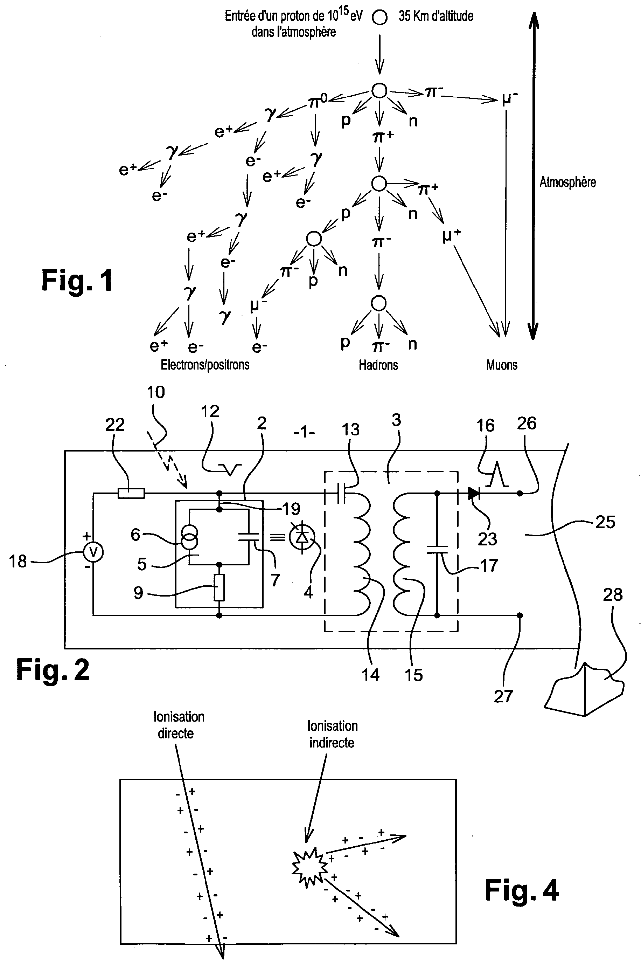

Le champ magnétique terrestre dévie la majeure partie de ces particules cosmiques. Une fraction importante des protons et des électrons se retrouve piégée autour des lignes de champ, formant une région communément appelée ceinture de radiations. L'autre partie, par un processus de spallation à partir des noyaux plus lourds présents dans l'atmosphère, produit des rayonnements et des particules ionisantes secondaires ou tertiaires (neutrons, photons, pions, muons, électrons, alpha, ions ...). Ce phénomène est appelé cascade atmosphérique. La figure 1 représente une telle cascade se produisant à des altitudes comprises entre 35 Km et 0 Km par rapport à la surface de la terre.

Par conséquent, entre la couche supérieure de l'atmosphère et le niveau de la mer, la formation des particules se déroule avec des bilans variables. Le flux de particules secondaires chargées est néanmoins atténué en raison de leur interaction avec les molécules présentes dans l'atmosphère. Il en résulte une prédominance des neutrons aux altitudes de vol des aéronefs.

Le flux neutronique présent dans l'atmosphère varie en fonction de la latitude et de l'altitude, et double à 1 500 m d'altitude par rapport au niveau du sol. Il varie également sous l'effet des changements de l'activité solaire.

En plus de l'environnement radiatif naturel d'origine cosmique, une composante au niveau du sol provient de l'activité naturelle du sol produite par les substances radioactives telles l'uranium, le thorium ou le potassium-40. Ceux-ci émettent des rayonnements gamma et bêta. D'autres environnements comportant des radiations ionisantes sont le nucléaire civil, le nucléaire militaire, le médical.

Selon l'invention, la diode utilisée est une diode polarisée en inverse, ou non polarisée, et est par ailleurs couplée à un transformateur d'impulsions. La polarisation en inverse de la diode a pour objet d'augmenter la zone de déplétion de la diode, et donc de favoriser, avant recombinaison, la collection des paires électron-trou créés par les particules ionisantes, électriquement chargées.

Le transformateur d'impulsion, par exemple un transformateur magnétique à grand rapport de transformation et à haute fréquence, transforme l'impulsion de courant en une impulsion de haute tension exploitée en aval.

L'invention a donc pour objet un générateur électrique excité par rayonnements ionisants, caractérisé en ce qu'il comporte un dispositif électronique à jonction semi-conductrice, comportant une diode polarisée en inverse ou non polarisée couplée à un transformateur d'impulsions qui transforme une impulsion de courant en une impulsion de haute tension. L'invention a ainsi pour objet un accumulateur composé d'une diode de silicium ou de tout autre matériau semi-conducteur, c'est-à-dire une jonction PN associée à deux électrodes, par contact ohmique, et à un circuit électronique, le transformateur. Le générateur transforme de bas niveaux de radiation ionisante en électricité via la génération de courants dans la diode.

L'efficacité d'un détecteur semi-conducteur dépend de nombreux facteurs : le type et l'énergie du rayonnement incident, sa géométrie, la densité et le numéro atomique du matériau utilisé, les éventuelles zones mortes dues aux propriétés de transport des porteurs et au mécanisme d'induction de signal. Pour le choix du matériau semi-conducteur, un grand nombre de paramètres interviennent : la mobilité des porteurs, la résistance intrinsèque, l'énergie d'ionisation..., le but étant de maximiser l'énergie déposée par unité de longueur et la part de l'énergie collectée, c'est-dire l'efficacité.

L'invention sera mieux comprise à la lecture de la description qui suit et à l'examen des figures qui l'accompagnent. Celles-ci ne sont présentées qu'à titre indicatif et nullement limitatif de l'invention. Les figures montrent :
- Figure 1 : déjà commentée, un schéma d'une cascade atmosphérique produite par un proton ;
- Figure 2 : une représentation schématique du générateur de l'invention ;
- Figure 3 : une étude du flux total des particules se trouvant dans l'atmosphère en fonction de l'altitude, aux altitudes considérées ;
- Figure 4 : un schéma différentiant l'ionisation directe et indirecte :
- Figure 5 : une étude du flux de protons dans un environnement spatial, à l'intérieur et à l'extérieur du véhicule, correspondant à un blindage d'aluminium de 1 g/cm2 ;
- Figure 6 : une représentation en coupe d'une jonction semi conductrice.

La figure 2 montre une représentation schématique du générateur 1 de l'invention. Ce générateur 1 comporte un dispositif électronique 2 à jonction semi-conductrice relié à un transformateur 3 d'impulsions. Le dispositif 2 comporte une jonction semi conductrice 4, représentée par son schéma électrique équivalent 5. Selon ce schéma 5, la jonction 4 comporte un générateur 6 de courant de fuite, en parallèle avec un condensateur 7 représentant une capacité de jonction, et une résistance représentant la résistance de jonction. Typiquement, la capacité 7 a une valeur de quelques pF, par exemple 80 pF, la résistance ayant une valeur très forte, par exemple de quelques MΩ. Le schéma équivalent est complété par une résistance de pied 9 de faible valeur. Lorsque le dispositif 2 est soumis à une irradiation cosmique 10, il produit une impulsion de courant 12, ici négative, d'amplitude faible.

Le transformateur 3 est de préférence couplé au dispositif 2 par l'intermédiaire d'un condensateur 13, utile pour empêcher une composante continue de passer dans le transformateur 3, d'y produire des pertes énergétiques inutiles, et éventuellement de contribuer à saturer le noyau de ce transformateur 3. Le transformateur 3 est un transformateur magnétique, avec des enroulements primaire 14 et secondaire 15 correctement bobinés pour produire une impulsion 16 avec une polarité positive choisie. De préférence, le transformateur 3 comporte en parallèle sur l'enroulement secondaire 15 un condensateur 17 de résonance pour accorder le transformateur 3 à une fréquence de délivrance des impulsions 16. Un jeu de diodes de redressement telle que 23 permet de redresser l'impulsion 16 et de la transformer, à l'aide du condensateur 17, en composante continue. Le transformateur joue ainsi un rôle de redressement, de convertisseur pour convertir l'impulsion de courant en tension.

La jonction semi conductrice 4 du générateur 1 peut être polarisée en inverse si une alimentation de quelques dizaines de volts est concevable avec le système et si le bilan énergétique final reste positif. Dans un exemple, cette polarisation inverse peut être simulée par une pile 18 connectée en parallèle sur la diode 4. Le pôle positif de la pile 18 est connecté à la cathode de la diode 4, le pôle négatif de la pile étant connecté à l'anode. Avec cette polarisation inverse, on augmente la largeur de la jonction. Pour éviter un courant de fuite inverse et un déchargement de la pile 18, la pile 18 peut être montée en série avec une diode polarisée en direct, c'est-à-dire avec la cathode de la diode reliée au pôle négatif de la pile 18, et son anode reliée, indirectement, au pôle positif de la pile 18. Dans la majorité des cas, on peut se passer de l'alimentation par la pile 18, la jonction 4 ne sera alors pas polarisée et possédera une zone de déplétion moins étendue. L'efficacité représentera environ 15% de l'efficacité correspondante à une zone de déplétion totale. La pile 18 est reliée à la jonction 4 par l'intermédiaire d'une résistance 22 permettant de minimiser les effets sur la pile 18 des impulsions de courant 11. La diode 4 est ainsi ici connectée entre la résistance 22 et l'anode de la diode 21.

La polarisation ou son absence peut dépendre de l'utilisation souhaitée

On utilise le générateur de l'invention de préférence avec une diode 4 montée sur une carte électronique 25 d'un circuit électronique, non représenté, mais alimenté par le générateur 1, aux bornes 26 et 27 en aval des diodes 23 et 24. La carte électronique 25 peut être contenue dans un boîtier 28 opaque aux rayonnements photoniques. Elle est par exemple montée à l'intérieur d'un véhicule spatial ou aéronautique. La carte 25 porte et sert en particulier à alimenter un capteur de vibrations, de température, d'irradiations, d'inertie ou autre, déporté dans le véhicule, sans avoir besoin de tirer des fils d'alimentation jusqu'à ce capteur pour l'alimenter électriquement.

Dans le cas de radiations ionisantes, que ce soit via l'ionisation directe comme c'est le cas pour des particules chargées (protons, ions lourds, muons, pions) ou que ce soit via l'ionisation indirecte, c'est-à-dire par création d'ions secondaires lors de réactions nucléaires (cas principalement des protons et des neutrons), celles-ci déposent leur énergie cinétique le long de leur trace.

Les particules chargées perdent leur énergie par interaction coulombienne avec les électrons du semi-conducteur. Des paires d'électron-trou sont générées, la quantité de paires créées étant proportionnelle à l'énergie déposée.

Quand une tension de polarisation inverse est appliquée sur la jonction PN, les charges minoritaires migrent d'un côté à l'autre de la jonction et la zone de déplétion également appelée zone de charge d'espace augmente. Le champ électrique est réparti sur toute la profondeur de la zone de déplétion. Une paire d'électron-trou générée dans la zone de déplétion est alors séparée par ce champ électrique : l'électron parvient à la cathode 19 et le trou, à l'anode 20. Le mouvement d'une paire crée donc une charge élémentaire aux électrodes de la diode. Si la paire électron-trou est générée en dehors de la zone de déplétion c'est-à-dire dans les régions neutres, les porteurs créés diffusent jusqu'à la limite de la zone de déplétion, par un mécanisme de diffusion ambipolaire. Ce processus a une durée plus longue que dans le cas où la paire électron-trou est générée dans la zone de déplétion, mais reste néanmoins plus rapide que le mécanisme de recombinaison de sorte que la production d'impulsion de courant se produit dans tous les cas. La diode est connectée à un circuit électronique, le transformateur 3, qui permet de récupérer les charges créées. Plus la zone de déplétion sera étendue, plus l'efficacité de la diode sera élevée. La largeur de la zone de déplétion est fonction de la concentration de dopage et de la tension de polarisation inverse appliquée à la diode. Elle peut être augmentée artificiellement en intercalant une région intrinsèque entre les régions de type N et de type P. Ceci conduit a un autre type de diode : la diode PIN. Si la polarisation inverse de la structure est suffisante, un champ électrique existe dans toute la zone intrinsèque.

Quand aucune tension de polarisation inverse est appliquée, la charge collectée est inférieure à la charge générée, mais reste suffisante pour générer une impulsion de courant aux bornes de la diode.

L'utilisation de ce type générateur est judicieuse dans le cas de systèmes difficilement accessibles et à faible consommation. Il ne fournit qu'une faible puissance mais a une durée de vie bien supérieure à des batteries conventionnelles puisque sa source d'énergie est inépuisable. Contrairement à une pile et dans le cas où la diode fonctionne sans batterie pour la polariser, il ne contient aucun élément toxique et nocif pour l'environnement : c'est un générateur sain.

L'utilisation des radiations ionisantes présentes dans les environnements spatiaux, avioniques, nucléaires, médicaux, à la place du tritium comme source d'énergie, a des avantages en ce qui concerne la sécurité et le conditionnement. Ce générateur ne contient aucun isotope radioactif. Comparé aux diodes à base de tritium, il a aussi l'avantage de ne pas générer d'électrons énergétiques qui entrainent des dommages internes dans le matériau. Comparé aux cellules solaires, il peut se placer n'importe où dans le système, proche des composants électriques à alimenter, et ainsi faciliter le câblage.

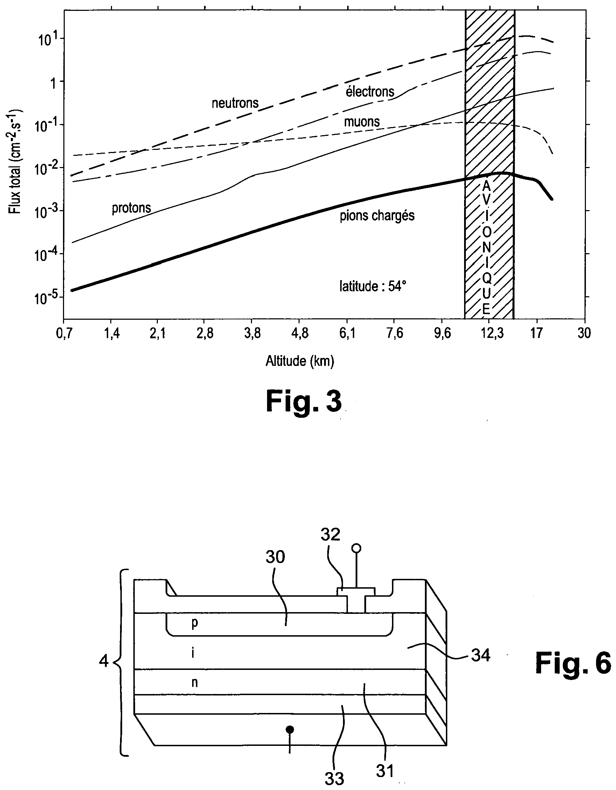

La quantité d'électricité générée dépend de l'environnement radiatif du générateur, c'est-à-dire du flux et du type de particules ionisantes. Ces radiations sont présentes dans l'atmosphère en faible quantité mais sont bien plus nombreuses dans le spatial. La figure 3 montre une étude du flux total des particules ionisantes se trouvant dans l'atmosphère en fonction de l'altitude, aux altitudes considérées, et en fonction des différents types de particules concernées. La figure 4 montre que dans la diode elle-même peuvent se produire des réactions nucléaires générant des ions, secondaires conduisant aussi à la création de paires électron-trou formant une impulsion de courant.

Suivant le type de particules, l'ionisation du semi-conducteur est plus ou moins importante. La quantité de paires électron-trou générée le long de la trace est fonction de l'énergie cédée par unité de longueur ou LET (Linear Energy Transfer), estimée en C/m, qui dépend de la nature de l'ion, du matériau semi conducteur et de son énergie.

Les paragraphes suivants estiment la charge créée dans le cas d'une diode de silicium de surface 1 cm2, non polarisée, et de profondeur de 500 µm, pour divers environnements radiatifs.

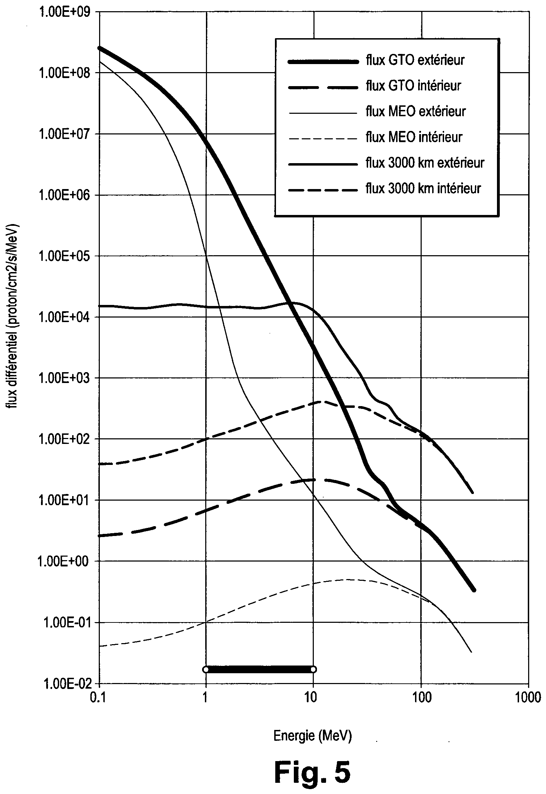

Dans un environnement spatial, en première approximation, seule la contribution des protons est prise en compte. Si l'hypothèse simplifiée d'une incidence normale au plan de la jonction est faite, les protons dont le parcours est inférieur à 500 µm déposeront toute leur énergie dans la diode. Ces protons correspondent à des énergies inférieures à 9 MeV. Les protons d'énergie supérieure ne déposeront par contre qu'une partie de leur énergie. Après calcul, il s'avère que chaque proton d'énergie inférieure à 9 MeV dépose entre 6 fC et 60 fC. La figure 5 fournit le flux de protons en fonction de l'énergie pour différents environnements spatiaux, une orbite moyenne intermédiaire (MEO), une orbite de transfert géostationnaire (GTO) et un environnement à 3000 km d'altitude. La figure 5 indique le flux à l'extérieur et à l'intérieur du véhicule spatial, c'est à dire après avoir traversé la structure d'1g/cm2 du véhicule spatial. Par exemple, pour un flux de particules entre 1 et 10 MeV de 26500 p/cm2/s qui correspond à un flux extérieur pour un environnement MEO, la charge totale déposée en une heure par les protons via l'ionisation directe (protons de faible énergie) est de 2.5 µC/h.

L'ionisation indirecte, créée par des protons d'énergies supérieures à 10 MeV, est négligée dans ces calculs car, bien que le flux des protons associés soit vingt fois supérieur, le dépôt de charges par proton est 3 000 fois plus faible.

Si une alimentation de 1 V est supposée aux bornes 26 et 27, l'énergie stockée est de 2.5 µWh soit 9 mJ. la puissance produite est de 2.5 µW/cm2. Cette puissance est suffisante pour alimenter temporairement (par exemple****) des capteurs et permet par exemple de produire 1 mW durant 1 ms à une tension de 1V toutes les 7 minutes. La génération est du même ordre de grandeur que la récupération d'énergie en radiofréquence (<1 µW/cm2) ou en acoustique (0.003∼0.96 µW/cm3).

Le tableau 1 ci-dessous présente la quantité de charges attendues pour les environnements spatiaux étudiés, dans le cas d'une diode polarisée en inverse avec déplétion totale et dans le cas d'une diode sans polarisation.

Dans le cas d'une diode polarisée (pour une tension d'environ 40V, la diode est totalement déplétée), son efficacité est améliorée d'un facteur 7. Son courant de fuite typique est de l'ordre de 50 nA. Sa consommation est donc de 5 µW par heure. La puissance produite est de 17 µW/cm2 soit un gain de 12 µW/cm2.

**Tableau 1**

| **Environnement** | **Nombre de protons entre 1-10 MeV** | | **Charges déposées si diode polarisée (déplétion totale de 500 µm) (µC/h)** | | **Charges déposées si diode non polarisée (µC/h)** | |
|---|---|---|---|---|---|---|
| | extérieur | intérieur | extérieur | intérieur | extérieur | intérieur |
| **MEO** | 26500 | 3 | **17** | 0.003 | **2.5** | 0.0005 |
| **GTO** | 2700000 | 160 | **1500** | 0.16 | **230** | 0.024 |
| **3000km** | 137000 | 2600 | **110** | 2.65 | **16** | **0.4** |

A l'extérieur du véhicule, on atteint des niveaux de puissance comparables à ceux produits par des cellules solaires par temps nuageux (150 µW/cm2).

Pour un environnement atmosphérique à 12 km d'altitude, valable pour les aéronefs, on peut compter l'action des neutrons hautes énergies, des protons, des muons et des neutrons thermiques sur le Bore10, dans le cas d'une diode non polarisée.

L'énergie moyenne déposée par un neutron de haute énergie, supérieure à 10 MeV, est de 0.03 fC alors que le flux est de 5 000 neutrons/cm2/h. L'énergie déposée sera de 0.15 pC/h.

De la même manière que pour le calcul dans un environnement spatial, chaque proton d'énergie entre 1 et 10 MeV déposera entre 0.04 pC et 0.4 pC avec une efficacité de 15% soit 0.006 pC et 0.06. pC Le flux des protons est de 7 protons/cm2/h, ce qui correspond à un dépôt de charge de 0.4 pC/h.

Un muon a un LET faible, considéré constant, et égal à 0.017 fC/µm et un parcours infini. Il déposera dans la diode une charge moyenne de 1.3 fC. Le flux de muons à 12 km est de 300 muons/cm2/h. La charge déposée par les muons est de 0.4 pC/h.

Pour amplifier la génération de courant, un semi-conducteur dopé, comme le silicium dopé au bore, peut être utilisé. Les neutrons thermiques sont des neutrons ayant une énergie cinétique inférieure à 0.625 eV et sont naturellement présents dans l'environnement atmosphérique. Ces neutrons ont une section efficace macroscopique d'interaction nucléaire très élevée avec le Bore10 (3 838 barns), qui représente 20% du bore naturel. Exposé à des neutrons thermiques, le Bore10 peut relâcher des particules alpha de 1,47 MeV (parcours 5.21 µm et LET=12 fC/µm) et du Lithium, de 0.84 MeV (parcours 2.5 µm et LET=23 fC/µm). L'énergie moyenne déposée par réaction nucléaire est 0.015 pC et le flux de neutrons thermiques à 12 km est environ de 5 000 neutrons/cm2/h. La probabilité de réaction nucléaire avec le Bore10 pour une concentration de bore de 1 exp21 atomes/cm3 et une épaisseur de 500 µm est de 0.04. La charge déposée par les neutrons thermiques sera en conséquence de 3 pC/h. La charge totale déposée dans la diode est alors d'environ 4 pC/h pour une diode polarisée, ce qui correspond à une puissance de 4 pW/cm2.. La contribution la plus importante est celle associée à la réaction des neutrons thermiques avec le Bore10.

Cette puissance permet de produire 1 mW durant 1 ms à une tension de 1V toutes les 70 heures. Pour augmenter la puissance, il est possible de mettre plusieurs batteries en série ou d'utiliser des diodes de plus grande surface.

L'effet électronique décrit est différent de l'effet photoélectrique. Ce dernier représente l'émission d'électrons par un matériau lorsque celui-ci est exposé à la lumière ou à un rayonnement électromagnétique de fréquence suffisamment élevée, qui dépend du matériau.

Les cellules selon l'invention sont constituées de semi-conducteurs, principalement à base de silicium (Si) ou d'autre semi-conducteurs : sulfure de cadmium (CdS), (InSb), tellurure de cadmium (CdTe), germanium (Ge), carbure de silicium (SiC), etc.. Elles se présentent sous la forme de fines plaques, rondes ou carrées, d'un centimètre ou de plusieurs dizaine de centimètres de coté, prises en sandwich entre deux contacts métalliques, pour une épaisseur de l'ordre du millimètre ou plus. La figure 6 montre une telle cellule. Une couche supérieure 30 de la cellule est composée de silicium dopé N. Dans cette couche, il existe une quantité d'électrons libres supérieure à une couche de silicium pur. La couche inférieure 31 de la cellule est composée de silicium dopé P. Cette couche possède en moyenne une quantité d'électrons libres inférieure à une couche de silicium pur, les électrons sont liés au réseau cristallin qui, en conséquence, est chargé négativement. Au moment de la création de la jonction P-N, les électrons libres de la région N rentrent dans la couche P et vont se recombiner avec les trous de la région P. Il existe ainsi, pendant toute la vie de la jonction, une charge positive de la région N au bord de la jonction (parce que les électrons en sont partis) et une charge négative dans la région P au bord de la jonction (parce que les trous en ont disparu) ; l'ensemble forme la Zone de Charge d'Espace (ZCE) et il existe un champ électrique entre les deux, de N vers P.

Ce champ électrique fait de la ZCE une diode, qui ne permet le passage du courant que dans un sens : les électrons peuvent passer de la région P vers la région N, mais pas en sens inverse ; inversement les trous ne passent que de N vers P. Dans l'invention, en ajoutant la polarisation inverse, en reliant la couche 30 au pôle positif de la pile 18 et en reliant la couche 31 au pôle négatif de la pile 18, on augmente l'épaisseur de la Zone de Charge d'Espace. Les particules qui traversent cette zone, normalement à son plan, ont donc d'autant plus de chemin à parcourir dans lequel elles sont susceptibles de créer des paires électron-trou plus nombreuses.

En fonctionnement, quand une particule arrache un électron à la matrice, créant un électron libre et un trou, sous l'effet de ce champ électrique, ils partent chacun à l'opposé : les électrons s'accumulent dans la région N, tandis que les trous s'accumulent dans la couche dopé P, créant l'impulsion 12. Ce phénomène est plus efficace dans la ZCE, où il n'y a pratiquement plus de porteurs de charges (électrons ou trous) puisqu'ils se sont annihilés, ou à la proximité immédiate de la ZCE : lorsqu'une particule chargée y crée une paire électron-trou, ils se séparent et ont peu de chance de rencontrer leur opposé, alors que si la création a lieu plus loin de la jonction, l'électron (respectivement le trou) nouveau conserve une grande chance de se recombiner avant d'atteindre la zone N (respectivement. la zone P). Des contacts électriques 32 et 33, dans l'invention, n'ont pas besoin de laisser passer la lumière. Dans l'invention, avec la pile 18, on augmente la taille de la zone sensible sans risque de recombinaison.

La cellule 4 est en silicium monocristallin ou en tout autre matériau semi-conducteur et comporte de préférence une zone intermédiaire 34 de semi-conducteur intrinsèque pour former une diode PIN.

Avec l'invention, on réalise donc un générateur électrique sensible aux rayonnements cosmiques particulaires en montant une diode en inverse en parallèle entre une pile de polarisation inverse et un transformateur d'impulsions ou avec seulement un transformateur d'impulsions. On peut créer ainsi un générateur de préférence directement monté sur la carte d'un circuit imprimé qui reçoit un capteur déporté.

## Revendications

1. - Générateur électrique excité par rayonnements ionisants, d'origine extérieure au générateur, **caractérisé en ce qu'**il comporte un dispositif électronique (2) à jonction semi-conductrice comportant une diode (4) polarisée en inverse ou non polarisée, couplée à un transformateur (3) d'impulsions qui transforme une impulsion de courant en une impulsion de haute tension.

2. - Générateur selon la revendication 1, **caractérisé en ce qu'**il comporte un dispositif annexe pour polariser la jonction en inverse.

3. - Générateur selon l'une des revendications 1 à 2, **caractérisé en ce que** le transformateur comporte un convertisseur transformant l'impulsion de courant en tension.

4. - Générateur selon l'une des revendications 1 à 3, **caractérisé en ce qu'**il comporte un condensateur monté en série entre le dispositif électronique et le transformateur.

5. - Utilisation d'un générateur selon l'une des revendications 1 à 4 pour alimenter un capteur, **caractérisé en ce que** le dispositif électronique à jonction semi-conductrice est monté sur une carte électronique d'un circuit d'un capteur alimenté par le générateur.

6. - Utilisation selon la revendication 5, **caractérisé en ce que** le dispositif électronique à jonction semi-conductrice est une diode PIN.

7. - Utilisation selon l'une des revendications 5 à 6, **caractérisé en ce que** le dispositif électronique à jonction semi-conductrice est contenu dans un boîtier opaque aux rayonnements photoniques.

## Patentansprüche

1. Stromgenerator, welcher durch ionisierende Strahlungen mit Ursprung außerhalb des Generators erregt wird, **dadurch gekennzeichnet, dass** er eine elektronische Vorrichtung (2) mit Halbleiterübergang aufweist, die eine in Sperrrichtung vorgespannte oder nicht vorgespannte Diode (4) umfasst, die mit einem Impulstransformator (3) gekoppelt ist, welcher einen Stromimpuls in einen Hochspannungsimpuls umwandelt.

2. Generator nach Anspruch 1, **dadurch gekennzeichnet, dass** er eine Zubehörvorrichtung aufweist, um den Übergang in Sperrrichtung vorzuspannen.

3. Generator nach einem der Ansprüche 1 bis 2, **dadurch gekennzeichnet, dass** der Transformator einen Wandler aufweist, der den Stromimpuls in Spannung umwandelt.

4. Generator nach einem der Ansprüche 1 bis 3, **dadurch gekennzeichnet, dass** er einen Kondensator aufweist, der zwischen der elektronischen Vorrichtung und dem Transformator in Reihe geschaltet ist.

5. Verwendung eines Generators nach einem der Ansprüche 1 bis 4, um einen Sensor zu speisen, **dadurch gekennzeichnet, dass** die elektronische Vorrichtung mit Halbleiterübergang auf einer Leiterplatte einer Schaltung eines Sensors angebracht ist, der von dem Generator gespeist wird.

6. Verwendung nach Anspruch 5, **dadurch gekennzeichnet, dass** die elektronische Vorrichtung mit Halbleiterübergang eine PIN-Diode ist.

7. Verwendung nach einem der Ansprüche 5 bis 6, **dadurch gekennzeichnet, dass** die elektronische Vorrichtung mit Halbleiterübergang in einem für die Photonenstrahlungen undurchlässigen Gehäuse enthalten ist.

## Claims

1. Electric generator excited by ionizing radiation of origin external to the generator, **characterized in that** it includes an electronic device (2) with a semiconductor junction including a reverse-biased or unbiased diode (4) coupled to a pulse transformer (3) that transforms a current pulse into a high-voltage pulse.

2. Generator according to Claim 1, **characterized in that** it includes an adjoining device for reverse-biasing the junction.

3. Generator according to either of Claims 1 and 2, **characterized in that** the transformer includes a converter transforming the current pulse into a voltage.

4. Generator according to one of Claims 1 to 3, **characterized in that** it includes a capacitor connected in series between the electronic device and the transformer.

5. Use of a generator according to one of Claims 1 to 4 for powering a sensor, **characterized in that** the electronic device with a semiconductor junction is connected on an electronic circuit board of a sensor powered by the generator.

6. Use according to Claim 5, **characterized in that** the electronic device with a semiconductor junction is a PIN diode.

7. Use according to either of Claims 5 and 6, **characterized in that** the electronic device with a semiconductor junction is contained in a housing that is opaque to photon radiation.
